# EUROPEAN PATENT SPECIFICATION

(11) **EP 3 084 032 B1**
(45) Date of publication and mention of the grant of the patent: **06.09.2017**
(21) Application number: 14816137.5
(22) Date of filing: 17.12.2014
(51) Int. Cl.: C23C 14/16, C25D 3/56, C23C 28/02

(54) **STEEL SUBSTRATE PROVIDED WITH CORROSION RESISTANT COATING WITH HIGH MELTING TEMPERATURE AND MANUFACTURING METHOD THEREOF**
STAHLSUBSTRAT MIT KORROSIONSBESTÄNDIGER BESCHICHTUNG MIT HOHER SCHMELZTEMPERATUR
SUBSTRAT EN ACIER MUNI D'UN REVÊTEMENT RÉSISTANT À LA CORROSION À HAUTE TEMPÉRATURE DE FUSION

(30) Priority: 18.12.2013 EP 13005885
(43) Date of publication of application: 26.10.2016
(73) Proprietor: Tata Steel Nederland Technology B.V., 1951 JZ Velsen-Noord (NL)
(72) Inventor: ZOESTBERGEN, Edzo, NL-1951 JZ Velsen-Noord (NL); VAN DE LANGKRUIS, Jörgen, NL-1951 JZ Velsen-Noord (NL); BLEEKER, Robert, NL-1951 JZ Velsen-Noord (NL)
(74) Representative: Blauw, Frans Gerard
(86) International application number: PCT/EP2014/025025
(87) International publication number: WO 2015/090621

(56) References cited:
- WO-A1-2008/025066
- WO-A1-2013/023906
- WO-A1-2013/091889
- WO-A1-2013/166429
- DE-A1- 4 438 608
- GB-A- 929 262
- JP-A- S5 837 188
- US-A- 5 043 230
- US-A- 5 691 071
- VAGGE S T ET AL: "Influence of strontium on electrochemical corrosion behavior of hot-dip galvanized coating", SURFACE AND COATINGS TECHNOLOGY, ELSEVIER, AMSTERDAM, NL, vol. 203, no. 20-21, 15 July 2009 (2009-07-15), pages 3092-3098, XP026142619, ISSN: 0257-8972, DOI: 10.1016/J.SURFCOAT.2009.03.026 [retrieved on 2009-03-24]

## Description

### Field of the invention

The invention relates to a steel substrate provided with a corrosion resistant Zn-based coating wherein the coating has a high melting temperature.

### Background of the invention

In applications where a steel substrate provided with a corrosion resistant coating is subjected to high temperature processes or high temperature environments there are only a limited number of coatings that are suitable to use.

High temperature processes are for instance forming operations like hot forming operations. In hot forming the material is preheated to a temperature typically in a range of about 880 - 930°C. The actual forming temperature should be high enough to allow the required local deformations in the part without tearing, but can be significantly lower than the preheat temperature to restrict the occurrence of micro-crack formation. In WO20120979 it has been disclosed that the blank temperature should be at least 500°C when placed in the hot forming press, more preferably 600°C, and still more preferably 650°C.

High temperature environments are for instance exhaust systems and flue tubes or housings for engines and the like.

In hot forming operations of steel blanks, Al-Si coatings and Zn-based coatings are currently being used. In a hot forming operation a coated steel blank is first subjected to an austenization heat treatment after which the blank is transported to the press, formed and rapidly quenched.

The Al-Si coatings perform well in hot pressing operations, but the disadvantage of these Al-Si coatings is that only a barrier corrosion protection is provided, not a cathodic corrosion protection such as provided by Zn-based coatings.

However, with Zn-based coatings it is much more complicated to carry out hot forming operations because of zinc diffusion into the substrate, zinc evaporation, the forming of micro-cracks due to solid metal induced embrittlement, part rupture due to liquid metal embrittlement and oxide formation issues. These phenomena are related to the specific processing conditions.

At too high temperatures or too long holding times the zinc evaporation is such that the remaining zinc weight is too low for sufficient cathodic protection. Another problem is the diffusion of Zn into the steel substrate and although still a cathodic protection is obtained with the resulting diffusion layer this protection is far less than with a Zn-only coating layer on the substrate.

Penetration of liquid Zn-phases of a Zn-based coating between steel substrate grain boundaries might occur during hot pressing operation resulting in macro-cracking. This might even lead to complete failure of the final product due to liquid metal embrittlement.

Another problem with Zn-based coatings in hot pressing operations is the control of surface oxidation. The oxidised surfaces of the final product require a post cleaning process, which at present is standard practice and can be done with shot blasting. However, the forming of very thick oxide layers has a negative effect on the remaining Zn-weight and hence on the corrosion protection offered by the resulting coating.

Further problems may arise with the further processing of hot pressed products wherein the coating type and the presence of oxides may have a negative effect on weldability, adhesive bonding and paintability.

In order to reduce these problems as much as possible with the currently used Zn-based coatings in hot forming there is only a small temperature/time window available for hot pressing operations.

### Objectives of the invention

It is an objective of the present invention to provide a substrate with a Zn-based corrosion resistant coating according to claim 1 that is able to withstand high temperatures.

It is another objective of the present invention to provide a substrate with a Zn-based corrosion resistant coating that is suitable to be used in hot forming operations.

It is another objective of the present invention to provide a substrate with a Zn-based corrosion resistant coating with means to prevent diffusion of Zn into the substrate.

It is another objective of the present invention to provide a substrate with a Zn-based corrosion resistant coating with means to prevent evaporation of the Zn-based coating.

It is still another objective of the present invention to provide a substrate with a Zn-based corrosion resistant coating with means to prevent oxidation of the Zn-based coating.

### Description of the invention

According to a first aspect of the invention one or more of the objectives of the invention are realized by providing a steel substrate provided with a Zn-based corrosion resistant coating, wherein the Zn-based coating has a melting temperature above 600°C and wherein the Zn-based coating is a Zn-Sr coating with a Sr content of ≥ 9 wt% or a Zn-Ca coating with a Ca content of ≥ 5 wt%.
In these Zn-based coatings the balance is Zn and inevitable impurities.

This temperature is below typical processing temperatures in hot-forming operations, but as disclosed in WO2012097976A1 and mentioned above hot forming may take place at lower temperatures such as 600 °C, provided that the plastic behaviour of the blank allows the required deformations.

The Mn, Sr or Ca content in the Zn-based coating decreases Zn-diffusion to a rate lower than with a pure zinc coating at temperatures below the coating melting temperature, and realizes the higher melting temperatures of Zn-based coatings, thus controlling the risks for micro-crack formation and liquid metal embrittlement respectively.

According to a further aspect it is provided that the Mn-content in the Zn-Mn coating is in the range of 19 - 30 wt%. In realizing higher melting temperatures of a Zn-based coating the addition of Mn is very effective. With a Mn-content in the range of ≥ 19 wt% the liquidus temperature of the coating for the lower end of this range is 700°C or above and the risk for liquid metal embrittlement is reduced. By increasing the Mn-content the liquidus temperature will also increase, but since the coating is to offer cathodic corrosion protection the Mn-content should not be increased above 60 wt% in order to still have enough Zn-content in the coating. Preferably the lower limit of the Mn-content is not lower than 19 wt% which means that the liquidus temperature of the coating is above 700°C. With such a Mn-content the coating is suitable for hot forming operations without the risk of liquid metal embrittlement.

If the Mn-content in the Zn-Mn coating is raised to 55 - 60 wt% the solidus temperature of the coating is above 950°C, which makes the coating suitable for preheating- and forming operations at 850-950°C, without risk of liquid metal embrittlement. However, at this Mn content the cathodic corrosion protection of the coating is noticeably less than with the preferred Mn range of 19 - 30 wt%.

To realize high enough temperatures in a Zn-Sr coating it is preferably provided that the Sr-content in the Zn-Sr coating is in the range of 9 - 14 wt% and more preferably in the range of 9 - 11 wt%. With the Sr-content in the latter range the melting temperature of the Zn-Sr coating is in the order of 830°C. In addition to the high melting temperature a further advantage is that the Zn-content of the coating is high resulting in that sufficient Zn is available for cathodic corrosion protection.

To realize high enough temperatures in a Zn-Ca coating it is provided that the Ca-content in the Zn-Ca coating is in the range of 5 - 24 wt% and more preferably in the range of 5 - 8 wt%. With the Ca-content in the latter range the melting temperature is in the order of 725°C. In addition to the high melting temperature the coating has a high Zn-content resulting in that sufficient Zn is available for cathodic corrosion protection.

According to a further aspect of the invention a diffusion barrier layer is provided between the substrate and the Zn-based coating layer. With the melting temperatures of the Zn-based coatings according to the invention diffusion of Zn into the substrate might easily occur when heated to an elevated temperature and in order to prevent Zn-diffusion a diffusion barrier layer is applied on the substrate.

A number of conductive oxides, such as chromium oxide (Cr2O3), indium oxide (InO2) and tin oxide (SnO2), along with conductive nitrides (for instance TiN), silicides (for instance MoSi₂), and borides can be used as diffusion barriers. Alternatively a Ni + Pd alloy could be used as a diffusion layer to prevent diffusion of zinc. The melting temperature of these diffusion barrier layers are all above 1000°C. These diffusion barrier layers can be applied by a number of different techniques including vapour deposition such as chemical vapour deposition, physical vapour deposition, sputtering and pyrolitic deposition.

According to a further aspect of the invention the diffusion barrier layer is a tungsten or tungsten alloy layer which has a melting temperature well above 1000°C. Such a tungsten or tungsten alloy layer will not react with Zn and will prevent diffusion of zinc into the substrate during preheating before hot forming. Diffusion of carbon from the substrate into the tungsten or tungsten alloy diffusion barrier layer may easily occur, but that will not hamper the working of the layer as a Zn-diffusion barrier layer. Depending on thickness of the barrier layer Zn diffusion will be prevented totally or at least to a large extent. Because of the high melting temperature of tungsten a barrier layer of this material is applied preferably by sputtering. The advantage of deposition by sputtering is that it is a relatively easy deposition method to carry out. Because of the effectiveness of tungsten as a barrier layer, a relatively thin barrier layer will be sufficient, that is a thickness in the range of 2-50 nm will be sufficient.

The barrier layer can also be used in other Zn or Zn-based corrosion resistant coatings than the coatings according to the invention. For instance the tungsten barrier layer can be applied on a substrate, such as a steel strip, before the Zn or Zn-based coating is applied by hot dip galvanizing or any other coating method known in the art.

According to still a further aspect of the invention an evaporation barrier is provided on top of the Zn-based coating layer. The high melting point of the Zn-based coating layers according to the invention aids to minimise the coating evaporation and maintain the cathodic corrosion protection by the coating. However, in order to further reduce the evaporation an additional coating is provided on top of the Zn-based coating layer according the invention. This top coating layer does not only prevent evaporation but also reduces the oxidation behaviour of the Zn-based coating layer. Where in the description "evaporation barrier" is used this will also mean a barrier layer with which oxidation of the Zn-based coating layer is reduced as far as applicable. For preventing evaporation it is also important that the diffusion of Zn in this top coating layer is limited. To realize all the above mentioned properties an oxide-based top coating layer with a thickness in the range of 5-1000nm is provided, consisting of for instance chromium oxide (Cr2O3), indium oxide (InO2) or tin oxide (SnO2). Also other oxide films may be possible. The oxides produce a closed surface on top of the coating also when the Zn-based coating layer becomes liquid.

The oxide-based top layer is deposited either as:
▪ a closed oxide layer, or
▪ as a coating layer that will form an oxide when in contact with air.
A top coating layer of TiAlN2 forms a continuously renewable aluminium oxide layer on the coating surface at high temperatures, for example during preheating in a hot forming process. This oxide helps to prevent the high-temperature degradation of the nitride.

The feature that the melting temperatures of the Zn-based coatings according to the invention are well above those of the commonly used standard Zn or Zn-based coatings makes a substrate with a Zn-based coatings according to the invention suitable for use in high temperature applications such as press-hardening operations. For that reason it is further provided that the steel substrate is a steel suitable for press-hardening. According to a further aspect if is provided that for this specific application the steel substrate is a strip of boron steel.

According to the invention it is further provided that the Zn-based coating is applied by means of vapour deposition for instance chemical vapour deposition (CVD) and physical vapour deposition (PVD). The deposition by means of PVD allows for a very controlled deposition of the Zn-based coating layer to the required thickness within a narrow range of deviation. This means that the thickness of the Zn-based coating layer can be less than the thickness of such a layer when deposited by means of a hot-dip process. A Zn-based coating applied by hot-dip coating will usually be in the order of 10µm, whereas a Zn-based coating applied by PVD will be in the range of 2 - 10µm and preferably in the range of 3 - 8µm. The more so if diffusion of Zn into the substrate is prevented by means of a barrier layer and evaporation and/or oxidation of constituents of the Zn-based coating layer by means of a top layer.

According to a further aspect of the invention it is provided that the diffusion barrier layer and evaporation/oxidation barrier layer are applied by means of physical vapour deposition which has the same advantages as described for the deposition of the Zn-based coating layer by means of physical vapour deposition. Physical vapour deposition can be carried out using for instance magnetron sputtering. The evaporation barrier layer can also be deposited using other deposition methods such as electroplating .

### non-inventive Example: substrate with ZnMn coating layer after hot-press forming

Steel substrates with dimensions 200 mm × 123 mm were cleaned with Chela clean KC-F25H from Foster, electro-plated at 50°C with a current density of 1.5A/dm2, using a bath with a pH of 5.6, containing zinc sulphate heptahydrate, manganese sulphate monohydrate and tri-sodium citrate dehydrate and subsequently pickled and rinsed. The resulting ZnMn coatings had a thickness of about 3 µm thickness and contained 40-50 wt.% Mn.

The produced ZnMn coated samples were heated in a Pananalytical X-Ray Diffractometer type Xpert Pro, equipped with a heating cell, in 3 minutes to 900°C, held at this temperature for 6 minutes and subsequently cooled to 400 °C in 1 minute and further to below 100°C within another 7 minutes. During the heating cycle two different gas atmospheres have been used: pure nitrogen or air. The heating cycle is similar to that used in preheat cycles for hot forming processes for car parts.

After the heating cycles the cross sections of the samples were coated with a thin gold coating and analysed. Samples have been investigated mainly by spectral EDX mapping on the SEM, using very high probe currents to increase the speed of analyses. The results show that after annealing in nitrogen the zinc has diffused into the Fe and formed an FeZn layer of about 4 µm on top of the substrate, and on top of that an Mn-oxide layer of about 2 µm has formed. After annealing in air all Mn and Zn have oxidised into a MnZn-oxide layer of 4 µm thick and a very thick layer of iron-oxide is formed (34 µm).

The results of the samples annealed in nitrogen show that with a single ZnMn layer the Zn will diffuse into the steel substrate to form an iron-zinc phase and the Mn will form an oxide layer. After subsequent hot forming the iron-zinc layer offers cathodic protection to the substrate and the Mn-oxide will constitute a barrier layer if it stays intact.

Adding a diffusion barrier layer in between the substrate and the ZnMn layer and an evaporation barrier layer on top of the ZnMn layer will result in even better cathodic protection by keeping the ZnMn layer more intact during annealing and thus have more Zn and Mn available for cathodic protection in the end product.

The results of the samples annealed in air show that a single ZnMn layer will fully oxidise during the preheat cycle and all potential for cathodic protection after hot forming has been lost in the preheat. This loss can be minimised by applying an evaporation barrier layer on top of the ZnMn coating, which will not only reduce evaporation but will also reduce oxidation of the ZnMn-coating layer.

## Claims

1. Steel substrate provided with a Zn-based corrosion resistant coating, **characterized in that** the Zn-based coating has a melting temperature above 600°C and wherein the Zn-based coating is a Zn-Sr coating with a Sr content in the range of 9 - 14 wt% or a Zn-Ca coating with a Ca content in the range of 5 - 24 wt%.

2. Steel substrate according to claim 1, wherein the Sr-content in the Zn-Sr coating is in the range of 9 - 11 wt%.

3. Steel substrate according to claim 1, wherein the Ca-content in the Zn-Ca coating is in the range of 5 - 8 wt%.

4. Steel substrate according to one or more of claims 1 - 3, wherein a diffusion barrier layer is provided between the substrate and the Zn-based coating layer.

5. Steel substrate according to claim 4, wherein the diffusion barrier layer is a tungsten or a tungsten alloy layer.

6. Steel substrate according to one or more of claims 1 - 5, wherein an evaporation barrier is provided on top of the Zn-based coating layer.

7. Steel substrate according to claim 6, wherein the evaporation barrier layer is an oxide layer or an oxide forming layer.

8. Steel substrate according to one or more of claims 1 - 7, wherein the steel substrate is a steel suitable for press-hardening.

9. Steel substrate according to claim 8, wherein the steel substrate is a strip of boron steel.

10. Method to manufacture a steel substrate according to one or more of claims 1 - 9, chararterised in that the Zn-based coating is applied by means of vapour deposition.

11. Method according to claim 10, wherein the diffusion barrier layer is applied by means vapour deposition or sputtering.

12. Method according to claim 10 or 11, wherein the oxide layer or an oxide forming layer is applied by means of physical vapour deposition.

## Patentansprüche

1. Stahlsubstrat mit einer Zn-basierten korrosionsbeständen Beschichtung, **dadurch gekennzeichnet, dass** die Zn-basierte korrosionsbestände Beschichtung eine Schmelztemperatur über 600 °C aufweist und wobei die Zn-basierte Beschichtung eine Zn-Sr-Beschichtung mit einem Sr-Anteil im Bereich von 9-14 Gew.-% oder eine Zn-Ca-Beschichtung mit einem Ca-Anteil im Bereich von 5-24 Gew.-% ist.

2. Stahlsubstrat nach Anspruch 1, wobei der Sr-Anteil in der Zn-Sr-Beschichtung im Bereich von 9-11 Gew.-% ist.

3. Stahlsubstrat nach Anspruch 1, wobei der Ca-Anteil in der Zn-Ca-Beschichtung im Bereich von 5-8 Gew.-% ist.

4. Stahlsubstrat nach einem oder mehreren der Ansprüche 1-3, wobei eine Diffusionssperrschicht zwischen dem Substrat und der Zn-basierten Beschichtungsschicht bereitgestellt ist.

5. Stahlsubstrat nach Anspruch 4, wobei die Diffusionssperrschicht eine Wolfram- oder Wolframlegierungsschicht ist.

6. Stahlsubstrat nach einem oder mehreren der Ansprüche 1-5, wobei eine Verdampfungssperrschicht auf der Zn-basierten Beschichtungsschicht bereitgestellt ist.

7. Stahlsubstrat nach Anspruch 6, wobei die Verdampfungssperrschicht eine Oxidschicht oder eine oxidbildende Schicht ist.

8. Stahlsubstrat nach einem oder mehreren der Ansprüche 1-7, wobei das Stahlsubstrat ein Stahl ist, der presshärtungsgeeignet ist.

9. Stahlsubstrat nach Anspruch 8, wobei das Stahlsubstrat ein Borstahlstreifen ist.

10. Verfahren zur Herstellung eines Stahlsubstrates nach einem oder mehreren der Ansprüche 1-9, **dadurch gekennzeichnet, dass** die Zn-basierte Beschichtung mittels Aufdampfen aufgetragen wird.

11. Verfahren nach Anspruch 10, wobei die Diffusionssperrschicht mittels Aufdampfen oder Aufstäuben aufgetragen wird.

12. Verfahren nach Anspruch 10 oder 11, wobei die Oxidschicht oder eine oxidbildende Schicht mittels physischem Aufdampfen aufgetragen wird.

## Revendications

1. Substrat en acier pourvu d'un revêtement anticorrosion à base de Zn, **caractérisé en ce que** ledit revêtement à base de Zn possède une température de fusion supérieure à 600°C et ledit revêtement à base de Zn étant un revêtement de Zn-Sr avec une teneur en Sr compris dans la plage allant de 9 à 14 % en poids ou un revêtement de Zn-Ca avec une teneur en Ca compris dans la plage allant de 5 à 24 % en poids.

2. Substrat en acier selon la revendication 1, ladite teneur en Sr dans le revêtement de Zn-Sr étant compris dans la plage allant de 9 à 11 % en poids.

3. Substrat en acier selon la revendication 1, ladite teneur en Ca dans le revêtement de Zn-Ca étant compris dans la plage allant de 5 à 8 % en poids.

4. Substrat en acier selon l'une ou plusieurs des revendications 1 à 3 , une couche barrière de diffusion étant disposée entre le substrat et la couche de revêtement à base de Zn.

5. Substrat en acier selon la revendication 4, ladite couche barrière de diffusion étant une couche de tungstène ou une couche d'alliage de tungstène.

6. Substrat en acier selon l'une ou plusieurs des revendications 1 à 5 , une barrière d'évaporation étant disposée sur le dessus de la couche de revêtement à base de Zn.

7. Substrat en acier selon la revendication 6, ladite couche barrière d'évaporation étant une couche d'oxyde ou une couche de formation d'oxyde.

8. Substrat en acier selon l'une ou plusieurs des revendications 1 à 7, ledit substrat en acier étant un acier approprié pour trempe à la presse.

9. Substrat en acier selon la revendication 8, ledit substrat en acier étant une bande d'acier au bore.

10. Procédé pour fabriquer un substrat en acier selon l'une ou plusieurs des revendications 1 à 9 , **caractérisé en ce que** le revêtement à base de Zn est appliqué au moyen d'un dépôt en phase vapeur.

11. Procédé selon la revendication 10, ladite couche barrière de diffusion étant appliquée au moyen d'un dépôt en phase vapeur ou d'une pulvérisation cathodique.

12. Procédé selon la revendication 10 ou 11, ladite couche d'oxyde ou ladite couche de formation d'oxyde étant appliquée au moyen d'un dépôt physique en phase vapeur.
